# EUROPEAN PATENT APPLICATION

(11) **EP 3 128 219 A1**
(43) Date of publication of application: **08.02.2017**
(21) Application number: 16182642.5
(22) Date of filing: 03.08.2016
(51) Int. Cl.: F16M 11/00, G03B 17/56

(54) **ELECTRONIC APPARATUS AND HOUSING SUPPORT STRUCTURE**

(30) Priority: 06.08.2015 JP 2015155838
(71) Applicant: Teac Corporation, Tokyo (JP)
(72) Inventor: SAKAGUCHI, Mitsuhiro, Chofu-shi, Tokyo (JP)
(74) Representative: Stevens, Jason Paul

(57) **Abstract**

An electronic apparatus (1, 60), such as a digital audio recorder, includes a housing (4). A plurality of foot pads (44, 50, 63) are disposed on a lower housing surface (4F) of the housing, for supporting the housing on a placement surface (3A). A protective sheet (43, 62) is disposed on the lower housing surface, offset from the foot pads, for protecting the lower housing surface. The foot pads are elastic, are compressed upon fastening the housing to a support stand device (2, 70) by clamping force of a fastening mechanism (19, 75) in placing the lower housing surface on the support stand device, and come to have a range equal to or less than a thickness (T) of the protective sheet. Preferably, the foot pads are in a channelled form. Each of the foot pads includes a stopper, disposed inside the channelled form, for regulating a compression level of pad compression to a predetermined target level.

## Description

### BACKGROUND OF THE INVENTION

### 1. Field of the Invention

The present invention relates to an electronic apparatus and housing support structure. More particularly, the present invention relates to an electronic apparatus and housing support structure, with which a housing can be supported stably in both of horizontal placement and a fastened state on a support stand device.

### 2. Description Related to the Prior Art

An electronic apparatus is generally used in a horizontally placed state on a surface of a desk, table or the like. Foot pads are arranged on a lower housing surface of a housing of the electronic apparatus, and support the housing. Material for the foot pads is an elastic material, such as rubber, as disclosed in JP-U 5-064548 and JP-A 8-296695. In general, three or four of the foot pads are arranged on the lower housing surface of the housing. The housing is supported at three or four points by use of the foot pads, and can be kept placed horizontally in a stable manner.

Examples of the electronic apparatus include a digital audio recorder for recording sounds or voices, photographic device for forming an image, and the like. The electronic apparatus is used in horizontal placement as a state of being placed horizontally on a floor or stand. However, the electronic apparatus can be coupled with a support stand device or floor stand, such as a tripod and the like, in a fastened state. The support stand device has a mount plate, of which a receiving surface receives coupling of the electronic apparatus. The housing of the electronic apparatus is placed on the support stand device by orienting the lower housing surface of the housing to the receiving surface. Clamping force of a fastening mechanism such as screws keeps the electronic apparatus coupled to the mount plate firmly.

If concentration of the clamping force of the screws occurs at one point in the lower housing surface of the housing to couple the electronic apparatus to the mount plate, deformation of the housing is likely to occur in the electronic apparatus in the course of an excessive increase in the clamping force. A protective sheet is preferably positioned between the receiving surface and the lower housing surface with a sufficiently large area for widely distributing the clamping force. Preferably, the protective sheet of elastic material stabilizes a state of contact between the lower housing surface and the receiving surface. The protective sheet may be prepared discretely from the electronic apparatus and the support stand device. However, a discrete structure of the protective sheet is likely to cause a problem of an incidental loss of the parts. Thus, the protective sheet is in a form attached firmly to the housing of the electronic apparatus.

It is therefore conceivable to dispose the foot pads for the horizontal placement and also the protective sheet for coupling to the support stand device together with the lower housing surface of the housing, so that the electronic apparatus can be stably oriented in any one of the horizontal placement and the fastened state.

However, a problem has been found, in that the foot pads for the horizontal placement may cause interference of the space at the time of coupling to the support stand device in the construction of providing both of the foot pads for the horizontal placement and the protective sheet for coupling to the support stand device.

Specifically, a protrusion height of the foot pads from the lower housing surface of the housing should be equal to or more than a thickness of the protective sheet for the purpose of functions of the foot pads for the horizontal placement. However, if a size of the receiving surface of the support stand device is larger than a size of the lower housing surface, or is so large as to interfere spatially with the foot pads for the horizontal placement, then the receiving surface comes in contact with the foot pads for the horizontal placement before contact with the protective sheet, because the foot pads for the horizontal placement are disposed between the lower housing surface and the receiving surface. In short, a clearance space is defined between the receiving surface and the protective sheet on the lower housing surface of the electronic apparatus.

In the presence of the clearance space between the protective sheet and the receiving surface, the housing of the electronic apparatus cannot be fastened in a stable orientation by use of screws. If the clamping force of the screws is applied to the housing strongly, portions of the lower housing surface without the foot pads are pulled toward the receiving surface by the clamping force. Serious deformation of the housing is likely to occur.

A conceivable structure for solving the problem is a removable form of the foot pads in relation to the housing. When a user wishes to couple the housing to the support stand device, the foot pads are removed from the housing. However, a new problem arises in that manipulating for the removal of the foot pads is required at the time of a change of the state from the horizontal placement to the fastened state of the support stand device. Also, there is another problem of an incidental loss of the foot pads removed from the housing. Difficulty in handling the housing to the user will be higher.

### SUMMARY OF THE INVENTION

In view of the foregoing problems, an object of the present invention is to provide an electronic apparatus and housing support structure, with which a housing can be supported stably in both of horizontal placement and a fastened state on a support stand device.

In order to achieve the above and other objects and advantages of this invention, an electronic apparatus includes a protective sheet, disposed on a lower housing surface of a housing, positioned between the lower housing surface and a receiving surface of a support stand device, for protecting the housing while the housing is fastened to the support stand device by clamping force of a fastening mechanism in placing the lower housing surface on the receiving surface. A plurality of elastic foot pads are disposed on the lower housing surface, offset from the protective sheet, for supporting the housing on a placement surface upon placing the housing thereon, wherein the foot pads are compressed elastically by the clamping force upon coupling the housing on the support stand device, and come to have a range equal to or less than a thickness of the protective sheet.

Preferably, the foot pads are three or more foot pads. Even when the foot pads are elastically compressed by weight of the housing, a protrusion height of the foot pads from the lower housing surface is still larger than the thickness of the protective sheet.

Preferably, the protective sheet is disposed at a centre of the lower housing surface, and the foot pads are disposed to surround the protective sheet.

In another preferred embodiment, while the foot pads are elastically compressed by weight of the housing, a protrusion height of the foot pads from the lower housing surface becomes substantially equal to the thickness of the protective sheet.

Preferably, the foot pads are two foot pads. The two foot pads and the protective sheet are arranged triangularly at vertex points of a triangle.

Preferably, the foot pads are in a channelled form.

Preferably, each of the foot pads includes a stopper, disposed inside the channelled form, for regulating a compression level of pad compression to a predetermined target level.

Preferably, the stopper is formed from elastic material.

Preferably, each of the foot pads is in an L shape on the lower housing surface, and has a first foot segment extending along the lower housing surface, and a second foot segment extending along the lower housing surface and perpendicularly to the first foot segment.

Also, a housing support structure for supporting a housing of an electronic apparatus includes a protective sheet, disposed on a lower housing surface of the housing, positioned between the lower housing surface and a receiving surface of a support stand device, for protecting the housing while the housing is fastened to the support stand device by clamping force of a fastening mechanism in placing the lower housing surface on the receiving surface. A plurality of elastic foot pads are disposed on the lower housing surface, offset from the protective sheet, for supporting the housing on a placement surface upon placing the housing thereon, wherein the foot pads are compressed elastically by the clamping force upon coupling the housing on the support stand device, and come to have a range equal to or less than a thickness of the protective sheet.

Consequently, a housing of the electronic apparatus can be supported stably in both of horizontal placement and a fastened state on a support stand device, because foot pads are disposed in a suitable compressible structure.

### BRIEF DESCRIPTION OF THE DRAWINGS

The above objects and advantages of the present invention will become more apparent from the following detailed description when read in connection with the accompanying drawings, in which:
Fig. 1 is a perspective view illustrating an electronic apparatus and a tripod to which the electronic apparatus is fastened;
Fig. 2 is a perspective view illustrating the electronic apparatus and a table where the electronic apparatus is placed;
Fig. 3 is a bottom perspective view illustrating the electronic apparatus;
Fig. 4A is a partial cross section illustrating the electronic apparatus in a non-loaded state;
Figs. 4B and 4C are partial cross sections illustrating the electronic apparatus in respectively the horizontal placement and a fastened state;
Fig. 5 is a partial cross section illustrating a comparative example of which a housing may deform;
Fig. 6 is a perspective view illustrating foot pads of a second preferred electronic apparatus;
Fig. 7A is a partial cross section illustrating the foot pads and the like in a non-loaded state;
Figs. 7B and 7C are partial cross sections illustrating the foot pads and the like in respectively the horizontal placement and the fastened state;
Fig. 8 is a bottom perspective view illustrating a third preferred electronic apparatus having two foot pads;
Fig. 9A is a partial cross section illustrating the electronic apparatus in a non-loaded state;
Figs. 9B and 9C are partial cross sections illustrating the electronic apparatus in respectively the horizontal placement and the fastened state;
Fig. 10 is a perspective view illustrating a sliding device for use with the electronic apparatus;
Fig. 11 is a partial cross section illustrating another preferred fastening mechanism having clamping claws.

### DETAILED DESCRIPTION OF THE PREFERRED

### EMBODIMENT(S) OF THE PRESENT INVENTION

### [First embodiment]

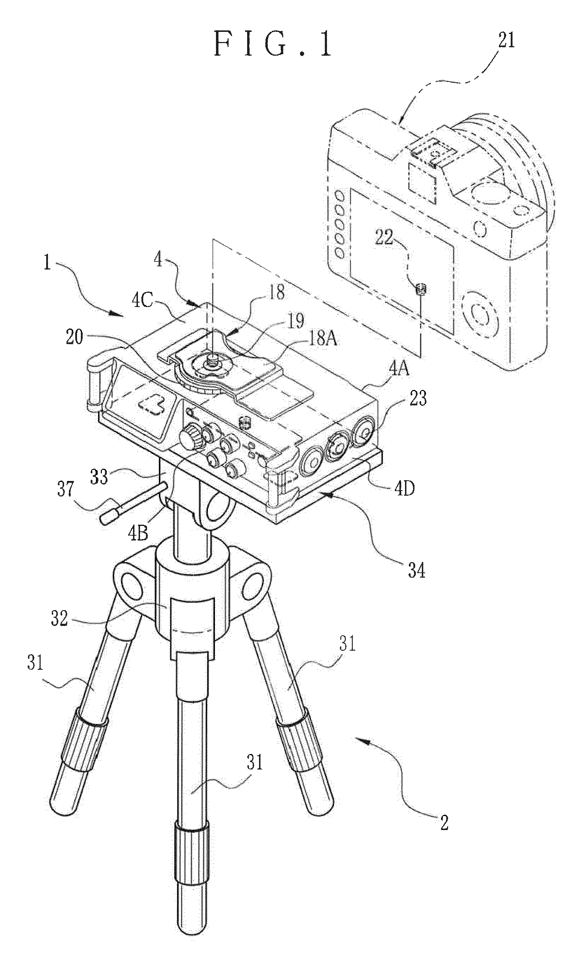

In Fig. 1, an electronic apparatus 1 is a digital audio recorder for recording sounds or voices input through a microphone, and writing digital data to a storage medium for the sounds or voices. An example of the storage medium is an IC memory. For example, the electronic apparatus 1 is used in combination with a digital camera 21 for imaging of a moving image. The digital camera 21 has a function of an audio recorder itself, but can be combined with the electronic apparatus 1 as external audio recorder to record sounds or voices with higher quality. In the combined use of the electronic apparatus 1 and the digital camera 21, audio data recorded by the electronic apparatus 1 is synthesized (combined) with the moving image recorded by the digital camera 21.

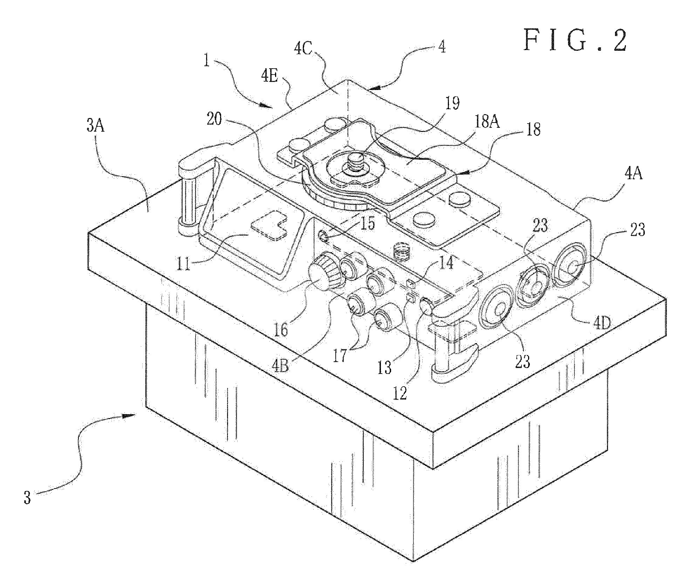

The electronic apparatus 1 is used in a state positioned on a tripod 2 for a camera. See Fig. 1. Also, a table plate 3 in Fig. 2 can be used for placement of the electronic apparatus 1 for use in a horizontal placement.

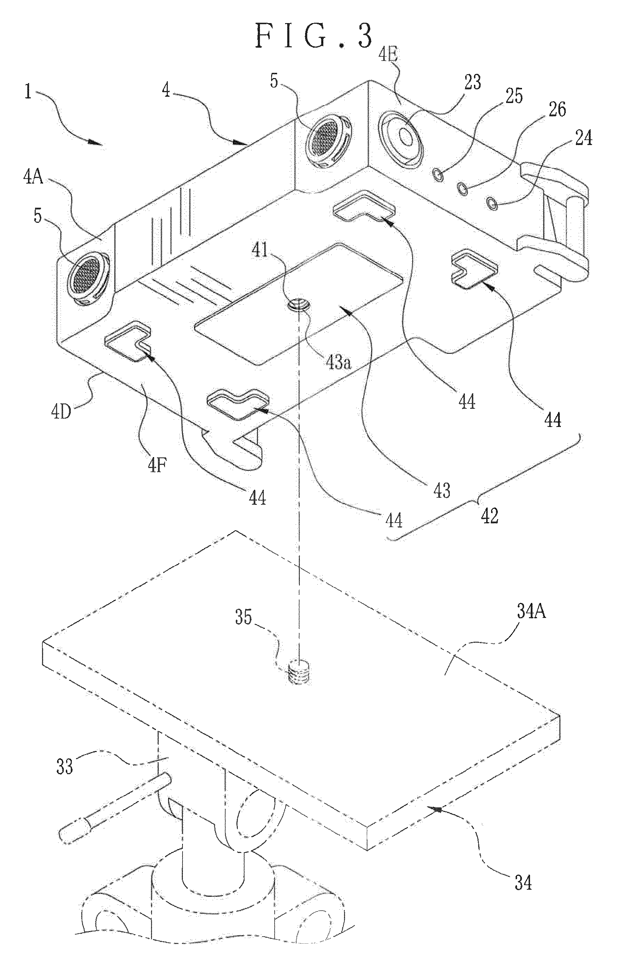

The electronic apparatus 1 includes a housing 4 and a built-in microphone 5, which is disposed on a front surface 4A of the housing 4 in Fig. 3. The built-in microphone 5 has right and left microphone units at right and left ends, and is operated for stereo recording of sounds.

In Fig. 2, various elements are disposed on a rear surface 4B of the housing 4, including a display panel 11 such as a liquid crystal display device (LCD), a record button 12 or record/stop button, a play button 13 or play/pause button, a stop button 14, a menu button 15, a dial wheel 16 and volume level wheels 17.

In Fig. 3, the housing 4 has a pair of lateral surfaces 4D and 4E. A line input terminal 23, an audio output terminal 24, a camera input terminal 25 and a camera output terminal 26 are disposed on the lateral surfaces 4D and 4E. An external microphone different from the built-in microphone 5 is connected to the line input terminal 23. A headphone, loud speaker or the like is connected to the audio output terminal 24 for outputting a played audio signal.

The camera input terminal 25 and the camera output terminal 26 are used for transmitting audio data in connection with the digital camera 21 by use of a signal cable. The camera input terminal 25 is for receiving audio data from the digital camera 21 to the electronic apparatus 1. The camera output terminal 26 is for sending audio data recorded by the electronic apparatus 1 to the digital camera 21.

When the record button 12 is depressed, recording of sounds input by the external microphone is started in connection with the built-in microphone 5 or the line input terminal 23. If the record button 12 is depressed in the course of the recording, the recording operation is interrupted. The volume level wheels 17 are manually rotatable to adjust a level of the recording.

When the play button 13 is depressed, the audio data in the storage medium is played back. When the play button 13 is depressed during the playback, the playback is interrupted. A headphone, which is connected to the audio output terminal 24, outputs sounds according to the audio data. Also, it is possible to use a loud speaker, which is driven to output the sounds according to the audio data.

When the menu button 15 is depressed, the display panel 11 is driven to display a control page for inputting various signals for setting. Also, the display panel 11 displays a selection page for selecting audio data required for playing. The dial wheel 16 is manually rotated to input various signals and selection.

In Figs. 1 and 2, the housing 4 has an upper housing surface 4C. A camera holder 18 is disposed on the upper housing surface 4C. The camera holder 18 is quadrilateral, and has a receiving surface 18A for coupling at the centre. A height of the receiving surface 18A is larger than a height of ends of the receiving surface 18A contacting the upper housing surface 4C. So a clearance space is defined between the camera holder 18 and the upper housing surface 4C.

A screw rod 19 (male thread) is formed with the camera holder 18 as a mechanism for fastening the digital camera 21. A distal end of the screw rod 19 is movable upwards to protrude from the receiving surface 18A. A rotatable dial wheel 20 is disposed at a proximal end of the screw rod 19. The dial wheel 20 is contained between the receiving surface 18A and the upper housing surface 4C.

When the dial wheel 20 is rotated, the screw rod 19 rotates. A screw hole 22 (female thread) is formed in a lower surface of the digital camera 21 for positioning to the tripod 2. In Fig. 3, a screw rod 35 (male thread) of the tripod 2 is illustrated. The screw hole 22 is according to the standards in the field of the camera. The screw rod 19 is helically engageable with the screw hole 22 of the digital camera 21, as the screw rod 19 is according to the same standards as the screw rod 35. The screw rod 19 couples the digital camera 21 to the camera holder 18 of the electronic apparatus 1.

The tripod 2 is a support stand device (or floor stand) for the electronic apparatus 1, and includes three tripod legs 31, a tripod support 32, a tripod head 33 and a mount plate 34 with a fastening mechanism. The tripod legs 31 are connected to the tripod support 32 in a pivotally movable manner. The tripod head 33 is disposed at an upper end of the tripod support 32. The mount plate 34 is disposed with the tripod head 33.

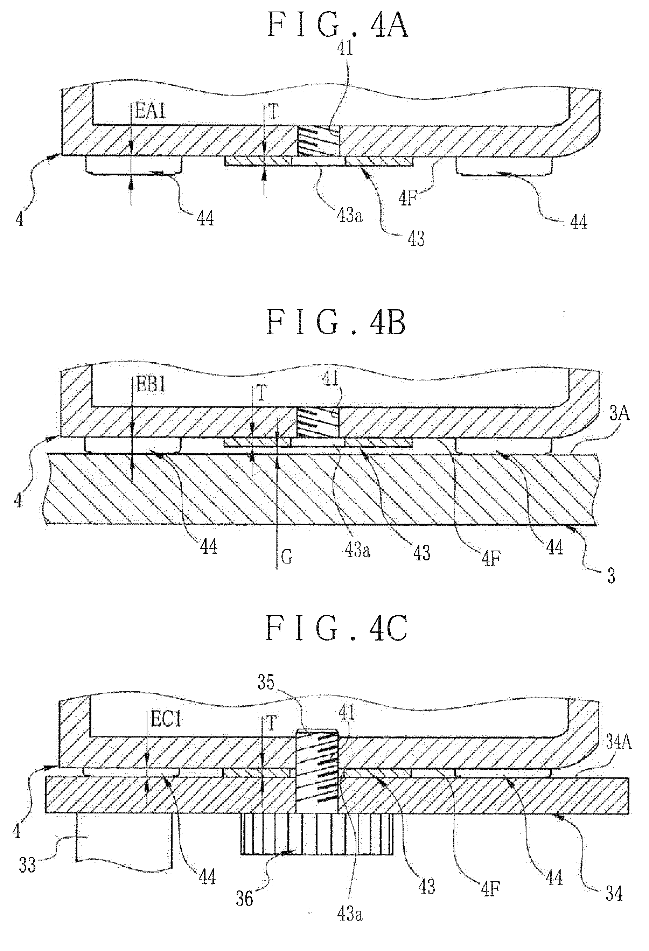

The mount plate 34 is quadrilateral in the same manner as the camera holder 18. A receiving surface 34A for coupling is a top of the mount plate 34. The receiving surface 34A has a larger size than a lower housing surface 4F of the housing 4. The mount plate 34 has the screw rod 35, which is a fastening mechanism for fastening the electronic apparatus 1 to the mount plate 34 of the tripod 2. A rotatable dial wheel 36 is disposed at a proximal end of the screw rod 35. See Fig. 4C. A distal end of the screw rod 35 protrudes from the receiving surface 34A.

The dial wheel 36 is formed with the screw rod 35 at the proximal end, and disposed on a lower side of the mount plate 34. The screw rod 35 is rotated by rotation of the dial wheel 36.

A screw hole 41 (female thread) of Figs. 4A and 4B is disposed in the electronic apparatus 1 for helical engagement with the screw rod 35, for the purpose of coupling the electronic apparatus 1 to the tripod 2. In general, the digital camera 21 is directly coupled to the tripod 2. However, the screw hole 41 of the electronic apparatus 1 is utilized for coupling the electronic apparatus 1 to the tripod 2 as illustrated in Fig. 1. Also, the digital camera 21 can be fastened to the camera holder 18 of the electronic apparatus 1. In short, the electronic apparatus 1 as an intermediate component indirectly couples the digital camera 21 to the tripod 2. A user can handle the tripod 2, the digital camera 21 and the electronic apparatus 1 as a group of the devices.

The tripod head 33 has a pan/tilt mechanism. A pan/tilt swing arm 37 extends from the tripod head 33 to the rear with an inclination. The pan/tilt swing arm 37 is manually operated to pan or tilt the mount plate 34 and the screw hole 22 in connection with the mount plate 34.

In Fig. 3, the screw hole 41 is formed at the centre of the lower housing surface 4F. A housing support structure 42 is provided in the lower housing surface 4F, and includes a protective sheet 43 and four foot pads 44. The housing 4 is placed on the receiving surface 34A by directing the lower housing surface 4F to the tripod 2. Clamping force between the screw rod 35 and the screw hole 41 fastens the housing 4 to the mount plate 34. The state of the fastening the electronic apparatus 1 to the tripod 2 is referred to as a fastened state.

The protective sheet 43 is in a quadrilateral shape and attached to the lower housing surface 4F. A sheet opening 43a (centre hole) is formed in the protective sheet 43 at the centre, and used for uncovering the screw hole 41 and receiving entry of the screw rod 35. The protective sheet 43 is attached to the lower housing surface 4F by aligning the sheet opening 43a with the screw hole 41.

When the housing 4 is in the fastened state, the protective sheet 43 protects the housing 4 by positioning between the lower housing surface 4F and the receiving surface 34A of the tripod 2. The housing 4 is fastened to the receiving surface 34A in a state of receiving the clamping force of the screw rod 35 and the screw hole 41 to the lower housing surface 4F. The protection with the protective sheet 43 is ensured as the protective sheet 43 provides wide distribution of the clamping force of the screw rod 35 and the screw hole 41. Also, the protective sheet 43 can effectively prevent occurrence of scratches on the lower housing surface 4F with friction of the receiving surface 34A. An example of material for the protective sheet 43 is flexible resin.

The foot pads 44 are disposed near to respectively four corners of the lower housing surface 4F. The foot pads 44 are so arranged so as not to overlap on the protective sheet 43 on the lower housing surface 4F of the housing 4. For example, the foot pads 44 are arranged around the protective sheet 43. An example of material for the foot pads 44 is elastic material, such as rubber or elastomer. While the housing 4 is placed horizontally on a placement surface 3A or table surface of the table plate 3 or the like to direct the lower housing surface 4F to the placement surface 3A, the foot pads 44 support the housing 4 on the placement surface 3A. A state of horizontally placing the housing 4 is hereinafter referred to as a horizontal placement.

Each of the foot pads 44 is in an L shape on the lower housing surface 4F, and has a first foot segment and a second foot segment extending perpendicularly to the first foot segment. The foot pads 44 are so arranged that their edges are parallel to side lines of the lower housing surface 4F. The L shape of the foot pads 44 is advantageous in high strength with resistance to external force applied in various directions, in comparison with other foot pads of a straight shape in one direction. The stable orientation of the housing 4 can be ensured by the foot pads 44 of this form even upon receiving external force.

Also, the foot pads 44 are formed in a solid shape without a channelled form, hollowness, cavities or openings.

In the tripod 2, a size of the receiving surface 34A is larger than the lower housing surface 4F of the housing 4. While the housing 4 is in the fastened state, the foot pads 44 are disposed between the lower housing surface 4F and the receiving surface 34A.

In Figs. 1 and 2, the electronic apparatus 1 is used in the two states including the horizontal placement and the fastened state. The foot pads 44 have such cushioning property (flexibility) that a protrusion height of the foot pads 44 from the lower housing surface 4F is suitably adjusted in any one of the two states.

Changes in the protrusion height of the foot pads 44 in the respective states are described now by referring to Figs. 4A-4C. In Fig. 4A, no load is applied to the foot pads 44. In Fig. 4B, horizontal placement of the housing 4 is illustrated. Weight of the foot pads 44 is received by the foot pads 44. In Fig. 4C, the fastened state is illustrated. Clamping force of the screw rod 35 and the screw hole 41 is applied to the foot pads 44.

In Fig. 4A, the foot pads 44 in a non-loaded state are not deformed elastically. A protrusion height EA1 of the foot pads 44 from the lower housing surface 4F is more than the thickness T of the protective sheet 43.

In Fig. 4B, the foot pads 44 are compressed by the weight of the housing 4 in the horizontal placement on the placement surface 3A. A protrusion height EB1 of the foot pads 44 from the lower housing surface 4F is kept larger than the thickness T of the protective sheet 43. Then a clearance space G is defined between the protective sheet 43 and the placement surface 3A. The housing 4 can be stably oriented in the horizontal placement because only the foot pads 44 support the housing 4. Note that elastic compression means compression of an elastic material by elastic deformation.

In Fig. 4C, the housing 4 is firmly coupled to the mount plate 34. The foot pads 44 are resiliently compressed by clamping force between the lower housing surface 4F and the receiving surface 34A. The clamping force is higher than weight of the housing 4 under gravity. The foot pads 44 have such cushioning property (flexibility) that a protrusion height EC1 from the lower housing surface 4F is equal to or less than a thickness T of the protective sheet 43 upon receiving the clamping force. Thus, the housing 4 can be stably coupled to the tripod 2 by contact of the protective sheet 43 with the receiving surface 34A of the tripod 2 without interference of the foot pads 44.

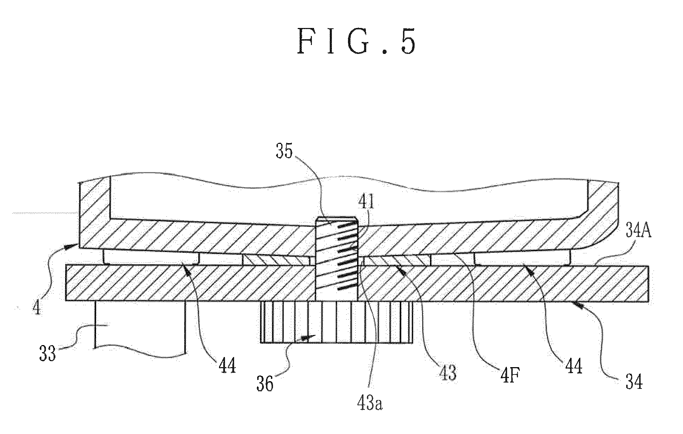

A comparative example is illustrated in Fig. 5, in which no adjustment is performed for a protrusion height of the foot pads 44. The protrusion height of the foot pads 44 does not becomes less than the thickness of the protective sheet 43 even upon receiving the clamping force in the fastened state. A space is formed between the protective sheet 43 and the receiving surface 34A, so that the housing 4 cannot be positioned on the mount plate 34 in a stable orientation with the receiving surface 34A. In Fig. 5, high clamping force from the screw rod 35 and the screw hole 41 is applied to the housing 4. The housing 4 is likely to deform, as the lower housing surface 4F is partially pulled toward the receiving surface 34A by the clamping force.

The foot pads 44 of Fig. 4C according to the invention are elastically compressed, and come to have a range equal to or less than the thickness of the protective sheet 43 because of the cushioning property of the foot pads 44. Thus, no problem in the comparative example of Fig. 5 will occur. Various specific data of the foot pads 44 are adjusted so that the protrusion height of the foot pads 44 is changed in the manners of Figs. 4A-4C, the specific data including the selection of the material, the thickness and size (area of receiving load) of the foot pads 44, and the like. Furthermore, other data are considered in combination to determine the cushioning property of the foot pads 44, the data including the weight of the housing 4, clamping force between the screw rod 35 and the screw hole 41 for fastening to the tripod 2, and the like.

When the foot pads 44 are compressed in the fastened state to such an extent that their protrusion height EC1 becomes as small as the thickness T of the protective sheet 43, then the equal clamping force is applied to the protective sheet 43 and the foot pads 44. In view of this, rigidity of the protective sheet 43 should be set equal to or higher than that of the foot pads 44 so as to prevent the protective sheet 43 from collapsing in comparison with the foot pads 44.

If rigidity of the protective sheet 43 is very high, it is supposed that no change occurs in the thickness T of the protective sheet 43 even upon receiving clamping force of the screw rod 35 and the screw hole 41. The protrusion height EC1 of the foot pads 44 in the condition of the clamping force can be set equal to the thickness T of the protective sheet 43. In contrast, if the protective sheet 43 has elasticity, it is necessary to consider a decrease in the thickness T of the protective sheet 43 upon receiving clamping force. The foot pads 44 should have such cushioning property that their protrusion height EC1 can be equal to or less than the thickness T.

Both of the protective sheet 43 and the foot pads 44 are disposed on the lower housing surface 4F of the housing 4. The cushioning property of the foot pads 44 is so determined that their protrusion height EB1 is more than the thickness T of the protective sheet 43 in the horizontal placement in Fig. 4B, and that the protrusion height EC1 is equal to or less than the thickness T in the fastened state in Fig. 4C.

In the horizontal placement, the protective sheet 43 does not contact the placement surface 3A as illustrated in Fig. 4B. The housing 4 is supported only by the four foot pads 44. In short, the protective sheet 43 does not interfere with the function of the foot pads 44 as support structure. It is possible to keep the housing 4 in a stable orientation in the horizontal placement.

In the fastened state, the thickness of the foot pads 44 becomes equal to or less than the thickness T of the protective sheet 43 as illustrated in Fig. 4C. An entire surface of the protective sheet 43 becomes contacted on the receiving surface 34A of the tripod 2 without interference of the foot pads 44. Consequently, the housing 4 of the electronic apparatus 1 can be positioned in a stable orientation. The housing 4 can be protected by the protective sheet 43 positioned between the lower housing surface 4F and the receiving surface 34A.

Also, the protective sheet 43 and the foot pads 44 do not require removal or attachment, and are free from loss in manual handling in the course of a change of the use between the horizontal placement and the fastened state, because the protective sheet 43 and the foot pads 44 are disposed fixedly on the lower housing surface 4F of the housing 4. It is possible to use the electronic apparatus 1 in a stable manner with simple handling while the electronic apparatus 1 is used in any one of the horizontal placement and the fastened state.

The feature of the present invention is useful specially for the electronic apparatus 1 of a portable use, for example, handling in an outdoor place. This is because the electronic apparatus 1 of the portable type is used by manual handling, in the horizontal placement of Fig. 2 and in the fastened state of Fig. 1 in consideration of the portable characteristic of the apparatus. The electronic apparatus 1 should be used with ensured stability in any one of the horizontal placement and the fastened state. The feature of the invention is remarkably advantageous for the use in the digital audio recorder as the electronic apparatus 1 frequently used outdoors in combination with a camera.

In the embodiment, the protective sheet 43 is formed from resin. However, other materials can be used for the protective sheet 43 for providing higher rigidity than the rigidity of the foot pads 44, for example, metal, hard rubber and the like.

In the present embodiment, the foot pads 44 are four at the corners of the lower housing surface 4F. However, the number of the foot pads 44 can be three or more in the arrangement suitable for supporting the housing 4. For example, the foot pads 44 can be three for the support at three points. The protective sheet 43 can be surrounded by the foot pads 44 arranged triangularly.

### [Second embodiment]

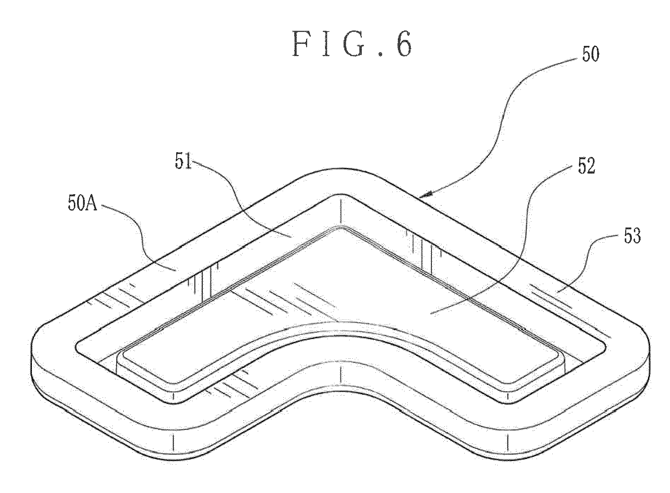

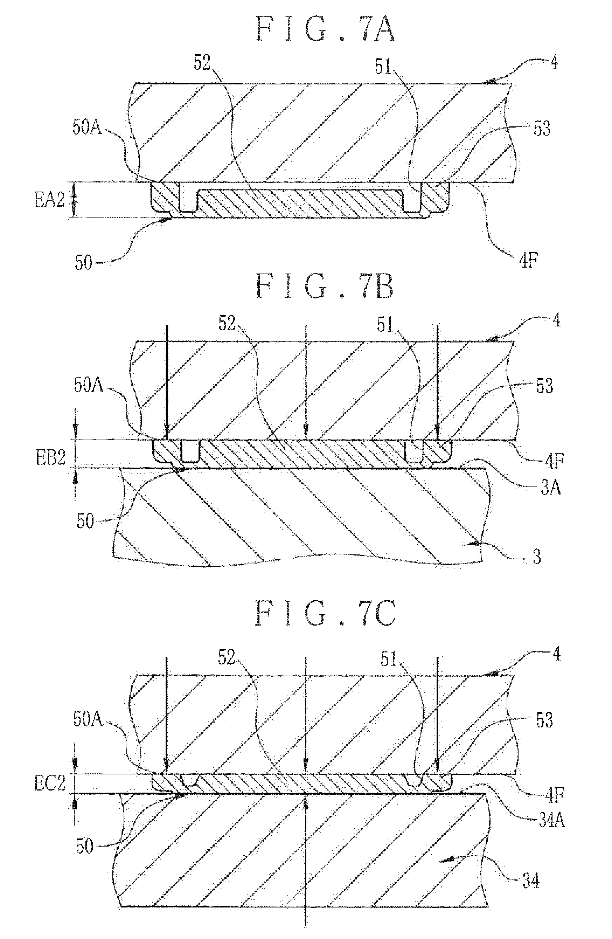

In Figs. 6 and 7A-7C, foot pads 50 for support in a channelled form (hollow form) are illustrated, in contrast with the foot pads 44 of the solid shape in the first embodiment. Specific data to determine cushioning property of the foot pads 44 according to the first embodiment are limited to a selection of the material and outer sizes because of the solid shape. However, cushioning property of the foot pads 50 of the second embodiment can be determined by using other specific data, such as a shape and size of an inner groove, in addition to the selection of the material and outer sizes. The advantage of the foot pads 50 in the second embodiment lies in facilitating the control of the cushioning property in the form. Elements similar to those of the above embodiment are designated with identical reference numerals.

The foot pads 50 are arranged and offset from the protective sheet 43 on the lower housing surface 4F of the housing 4 in the same manner as the foot pads 44 of the first embodiment. Each of the foot pads 50 is in an L shape on the lower housing surface 4F, and has a first foot segment and a second foot segment extending perpendicularly to the first foot segment. Edges of the foot pads 50 are parallel to side lines of the lower housing surface 4F. An L shaped groove 51 is formed in the foot pads 50 to provide a channelled form. The L shaped groove 51 is formed as a cut in an upper surface 50A, which contacts the lower housing surface 4F.

Even though the outer shape and the material for the foot pads 50 are equal, the cushioning property of the foot pads 50 can be changed by adjusting the width, depth and sizes of the L shaped groove 51. This is an advantage of the feature of the foot pads 50 over a structure of foot pads of a solid shape. Also, the cushioning property of the foot pads 50 can be finely adjusted by finely changing the width, depth and sizes of the L shaped groove 51.

In each of the foot pads 50, the L shaped groove 51 extends along a line of the L shape of the foot pads 50. L shaped foot segments 53 are defined by an outer edge of the L shaped groove 51. A smaller projection (island portion) is defined by an inner edge of the L shaped groove 51 in a smaller form than the L shape of the foot pad 50. A stopper 52 is constituted by the projection (island portion), and regulates a compression level of pad compression of the foot pad 50 to a predetermined target level. The stopper 52 is included in one piece of the foot pad 50 because of the L shaped groove 51.

The foot pads 50 are retained on the housing 4 by attachment of an upper surface of the L shaped foot segments 53 to the lower housing surface 4F. The upper surface of the stopper 52 is defined with a smaller height than a height of the L shaped foot segments 53. See Fig 7A.

In Figs. 7A-7C, changes of the protrusion height of the foot pads 50 are illustrated for the plural states including a non-loaded state, the horizontal placement and the fastened state. In Fig. 7A, the foot pads 50 are not deformed elastically in the non-loaded state. A protrusion height EA2 from the lower housing surface 4F is more than the thickness T of the protective sheet 43. An upper surface of the stopper 52 is lower than the L shaped foot segments 53, and does not contact the lower housing surface 4F in the non-loaded state.

The housing 4 is in the horizontal placement in Fig. 7B. The stopper 52 contacts the lower housing surface 4F as the foot pads 50 are compressed elastically by the weight of the foot pads 44. The weight of the housing 4 is received only with the L shaped foot segments 53 in a state without contact between the stopper 52 and the lower housing surface 4F. The foot pads 50 are compressed relatively easily. However, the stopper 52 and the L shaped foot segments 53 come to receive the weight of the housing 4 after the L shaped foot segments 53 are collapsed to contact the stopper 52 on the lower housing surface 4F.

As the load required for compressing the foot pads 50 is increased, the compression level of the foot pads 50 is regulated to the target level. In short, the protrusion height of the foot pads 50 from the lower housing surface 4F becomes a protrusion height EB2 in Fig. 7B by the regulation of the stopper 52. The protrusion height EB2 is more than the thickness T of the protective sheet 43. In the horizontal placement, the foot pads 50 contact the placement surface 3A. A clearance space is defined between the protective sheet 43 and the placement surface 3A in the same manner as Fig. 4B.

In the fastened state of the housing 4 to the mount plate 34 in Fig. 7C, the clamping force equal to or more than the weight of the housing 4 is applied to the foot pads 50. The foot pads 50 are further compressed resiliently to decrease their protrusion height. As the stopper 52 is included in the elastic piece of the foot pads 50 of the elastic material, the stopper 52 is compressed together with the L shaped foot segments 53. In the fastened state, a protrusion height EC2 of the foot pads 50 from the lower housing surface 4F becomes equal to or less than the thickness of the protective sheet 43. It is possible in the fastened state to couple the housing 4 of the electronic apparatus 1 in a stable orientation because distribution of the clamping force can be wide by contact of the protective sheet 43 with the receiving surface 34A in the same manner as the first embodiment.

Also, the stopper 52 has cushioning property (flexibility) because of the same material as the foot pads 50. The stopper 52 can be prevented from breakage even upon receiving the clamping force.

The cushioning property of the foot pads 50 is so determined that the foot pads 50 have the protrusion height EB2 in the horizontal placement, and have the protrusion height EC2 in the fastened state. The cushioning property in the form of the foot pads 50 can be controlled with greater ease than the solid shape according to the first embodiment, because features related to the L shaped groove 51 can be additional specific data of the foot pads 50 in addition to the selection of the material and outer sizes owing to the channelled form (hollow form) of the foot pads 50. In conclusion, the channelled form of the foot pads 50 is advantageous.

In the embodiment, the foot pads 50 have the L shaped groove 51 for the channelled form. However, a cavity, hole, opening, channel, slit or other negative shape can be formed in the foot pads 50 in place of the L shaped groove 51, or in addition to the L shaped groove 51.

The stopper 52 is included in the single elastic piece having each of the foot pads 50. However, the stopper 52 can be formed discretely from the foot pads 50. In view of a lower cost of manufacture, the structure of the stopper 52 of the single piece having the foot pads 50 is more advantageous.

### [Third embodiment]

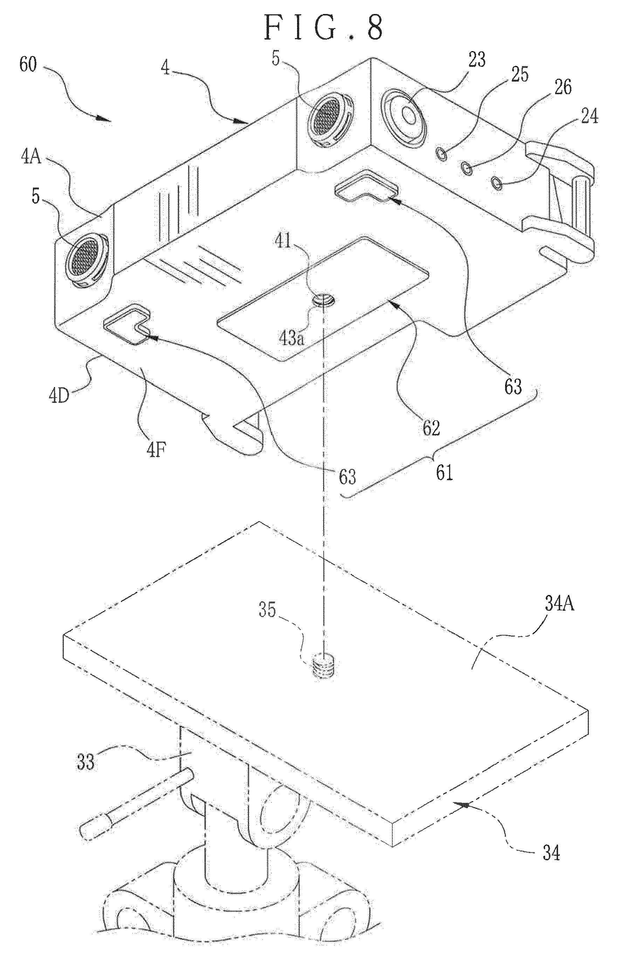

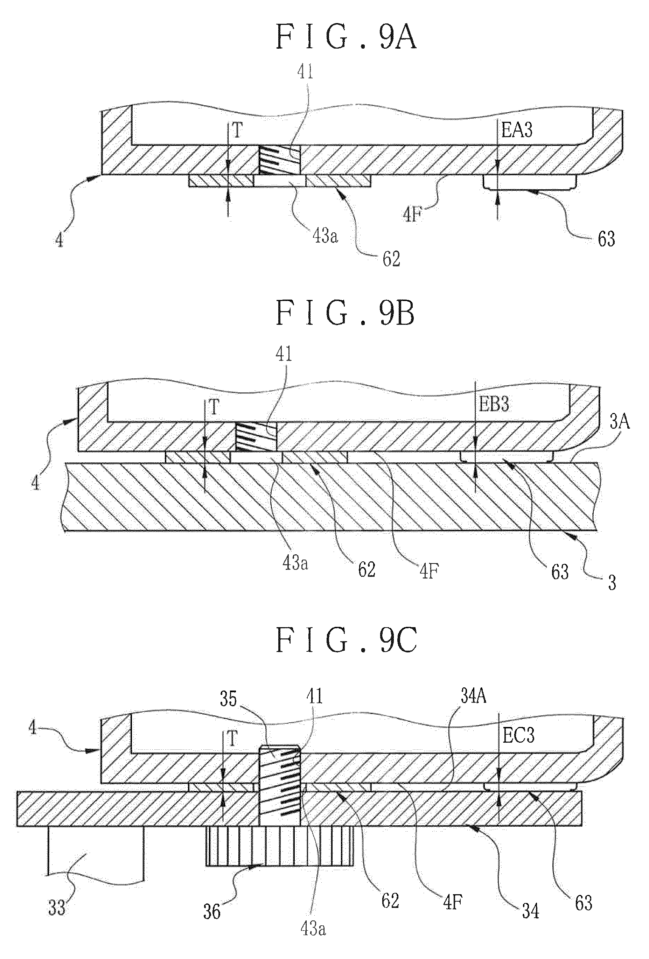

In Figs. 8 and 9A-9C, a third preferred electronic apparatus 60 is illustrated. A protective sheet 62 is functioned additionally for support. Two foot pads 63 for support are combined with the protective sheet 62 for supporting the housing 4. This is effective in reducing the number of the foot pads 63, to reduce the total of the relevant parts in a housing support structure because of the use of the protective sheet 62.

In the electronic apparatus 60 of the embodiment, a housing support structure 61 includes the protective sheet 62 and the foot pads 63. The protective sheet 62 is basically the same as the protective sheet 43 of the first embodiment, but has a difference in its additional use for a support.

The foot pads 63 are offset from the protective sheet 62 on the lower housing surface 4F. For example, the foot pads 63 are nearer to edges of the lower housing surface 4F than the protective sheet 62. The protective sheet 62 and the foot pads 63 are arranged triangularly at three points of a triangle. An example of material of the foot pads 63 is elastic material in the same manner as the foot pads 44 and 50.

Also, the foot pads 63 are in the L shape in the same manner as the first and second embodiments. Note that the foot pads 63 are solid in the embodiment, but can be formed in a channelled form in the same manner as the second embodiment.

The cushioning property of the foot pads 50 is determined according to the selection of the material and outer sizes, in order to adjust the protrusion height in each of the plural states from the lower housing surface 4F. Changes in the protrusion height of the foot pads 63 are described below. The foot pads 63 in a non-loaded state are not deformed elastically in Fig. 9A. A protrusion height EA3 from the lower housing surface 4F is more than the thickness T of the protective sheet 62.

In Fig. 9B, the foot pads 63 are elastically compressed by the weight of the housing 4, which is in the horizontal placement. Then a protrusion height EB3 of the foot pads 63 from the lower surface is equal to the thickness T of the protective sheet 62. The protective sheet 62 contacts the placement surface 3A together with the foot pads 63, and is functioned as a support for the housing 4.

In the fastened state of the housing 4 on the mount plate 34 in Fig. 9C, the foot pads 63 are elastically compressed by the clamping force between the lower housing surface 4F and the receiving surface 34A. A protrusion height EC3 of the foot pads 63 becomes equal to or less than the thickness T of the protective sheet 62.

A structure of the foot pads 63 with cushioning property is so determined that a protrusion height of the foot pads 63 becomes the protrusion heights EB3 and EC3 of Figs. 9B and 9C in both of the horizontal placement and the fastened state. In the solid shape of the foot pads 63 of the first and third embodiments, the cushioning property of the foot pads 63 is adjusted by selection of a material and adjusting its outer sizes. In the channelled form of the foot pads 63 of the second embodiment, the cushioning property of the foot pads 63 is adjusted by selection of a material, adjusting its outer sizes, and also adjusting a size of a groove or the like.

Thus, the housing 4 is kept supported by the protective sheet 62 and the foot pads 63 because the protrusion height of the foot pads 63 from the lower housing surface 4F is equal to the thickness of the protective sheet 62 while the housing 4 is in the horizontal placement. The protective sheet 62 is functioned additionally as a foot pad. It is possible to reduce the number of the foot pads in comparison with the first embodiment, to reduce the number of the relevant parts, in addition to the effect similar to the first embodiment. Also, the housing 4 is supported by the three points of the protective sheet 62 and the foot pads 63 which are arranged in a triangular arrangement. Orientation of the housing 4 can be kept stable in the course of the horizontal placement.

Also, the foot pads 63 in the embodiment can be shaped in a channelled form (hollow form) in the same manner as the second embodiment. A stopper can be provided inside the channelled form. In the horizontal placement of Fig. 9B, a target level for the compression level is so determined that a protrusion height of the foot pads 63 having the stopper is limited to the value EB3. In the horizontal placement, the structure of the stopper prevents the protrusion height of the foot pads 63 from being smaller than the thickness of the protective sheet 62 even upon compression of the foot pads 63. The foot pads 63 are regulated by the stopper and come to have the protrusion height equal to the thickness of the protective sheet 62.

The protrusion height EB3 of the foot pads 63 in the horizontal placement in Fig. 9B is changed to the protrusion height EC3 in the coupling state of Fig. 9C upon further deformation in the elastic manner. It is preferable to form the additional stopper from elastic material in the same manner as the second embodiment so that the stopper can deform elastically.

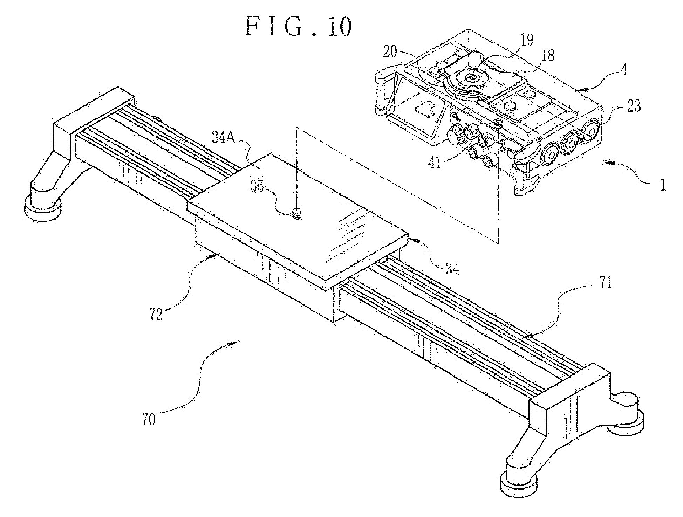

In the above embodiments, the tripod 2 is the support stand device (or floor stand) for coupling to the electronic apparatus in the invention. In Fig. 10, a sliding device 70 as a support stand device (or floor stand) is illustrated. The sliding device 70 is a structure the same as that disclosed in U.S. Pat. Pub. 2015/234,258 (corresponding to JP-B 5568188), and includes a rail mechanism 71 and a slider 72. The slider 72 has the mount plate 34 in the same form as the tripod 2, for use in coupling the electronic apparatus. The feature of the embodiment is effective as the stable orientation of the electronic apparatus is required even in combination with the sliding device 70. Note that other examples of the support stand devices can be used in place of the tripod 2 and the sliding device 70 in a condition of having a receiving surface for receiving a lower housing surface of the housing.

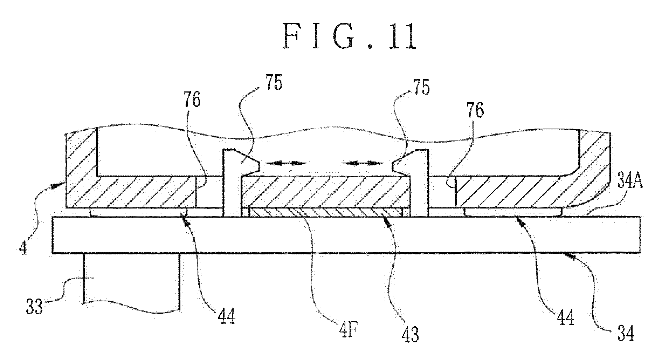

In the above embodiments, the fastening mechanism including the screw rod is used for the coupling portion for coupling the electronic apparatus in the invention. However, various examples of the fastening mechanism can be used for fastening the housing 4 on the support stand device by clamping force. In Fig. 11, an example of fastening mechanism is illustrated, and has a pair of clamping claws 75. A pair of coupling holes 76 as a fastening mechanism are formed in the lower housing surface 4F of the housing 4, in place of the screw hole. For coupling, the lower housing surface 4F is oriented on the receiving surface 34A toward the support stand device. The clamping claws 75 are engaged with the coupling holes 76 firmly to position the housing 4 on the mount plate 34. Also, a sliding mechanism (not shown) is associated with the clamping claws 75, and keeps the clamping claws 75 movable between a first position and a second position. The clamping claws 75 in the first position are engaged with edges of the coupling holes 76. The clamping claws 75 in the second position are released from the coupling holes 76, so that the housing 4 is positioned removably from the mount plate 34.

Also, the fastening mechanism can be a clamper or a band, for squeezing partially the electronic apparatus and partially the support stand device, in place of the screws and the clamping claws in the above embodiment

In the above embodiment, the electronic apparatus is the digital audio recorder. However, an electronic apparatus of the invention can be other electronic apparatuses for positioning in the horizontal placement and the fastened state. Examples of the electronic apparatuses are a photographic device (camera), illumination device and the like. Various changes and modifications of the above embodiment can be added in the embodiments.

According to a preferred embodiment mode of the invention, furthermore, a groove is formed in an upper surface of the foot pads oriented on the lower housing surface, and including a first groove channel and a second groove channel extending from the first groove channel in an L shape.

Preferably, furthermore, a stopper projection is disposed to project from an inner surface of the groove toward the lower housing surface, and having a smaller height than the upper surface in the foot pads.

Preferably, the height of the stopper projection is larger than the thickness of the protective sheet.

Although the present invention has been fully described by way of the preferred embodiments thereof with reference to the accompanying drawings, various changes and modifications will be apparent to those having skill in this field. Therefore, unless otherwise these changes and modifications depart from the scope of the present invention, they should be construed as included therein.

## Claims

1. An electronic apparatus comprising:
a protective sheet (43, 62), disposed on a lower housing surface (4F) of a housing (4), positioned between said lower housing surface and a receiving surface (34A) of a support stand device (2, 70), for protecting said housing while said housing is fastened to said support stand device by clamping force of a fastening mechanism (19, 75) in placing said lower housing surface on said receiving surface;
a plurality of elastic foot pads (44, 50, 63), disposed on said lower housing surface, offset from said protective sheet, for supporting said housing on a placement surface (3A) upon placing said housing thereon, wherein said foot pads are compressed elastically by said clamping force upon coupling said housing on said support stand device, and come to have a range equal to or less than a thickness (T) of said protective sheet.

2. An electronic apparatus as defined in claim 1, wherein said foot pads are three or more foot pads;
even when said foot pads are elastically compressed by weight of said housing, a protrusion height of said foot pads from said lower housing surface is still larger than said thickness of said protective sheet.

3. An electronic apparatus as defined in claim 1 or 2, wherein said protective sheet is disposed at a centre of said lower housing surface, and said foot pads are disposed to surround said protective sheet.

4. An electronic apparatus as defined in claim 1, wherein while said foot pads are elastically compressed by weight of said housing, a protrusion height of said foot pads from said lower housing surface becomes substantially equal to said thickness of said protective sheet.

5. An electronic apparatus as defined in claim 1 or 4, wherein said foot pads are two foot pads;
said two foot pads and said protective sheet are arranged triangularly at vertex points of a triangle.

6. An electronic apparatus as defined in any one of claims 1 to 5, wherein said foot pads are in a channelled form.

7. An electronic apparatus as defined in claim 6, wherein each of said foot pads includes a stopper, disposed inside said channelled form, for regulating a compression level of pad compression to a predetermined target level.

8. An electronic apparatus as defined in claim 7, wherein said stopper is formed from elastic material.

9. An electronic apparatus as defined in any one of claims 1 to 8, wherein each of said foot pads is in an L shape on said lower housing surface, and has a first foot segment extending along said lower housing surface, and a second foot segment extending along said lower housing surface and perpendicularly to the first foot segment.

10. A housing support structure for supporting a housing (4) of an electronic apparatus, comprising:
a protective sheet (43, 62), disposed on a lower housing surface (4F) of said housing, positioned between said lower housing surface and a receiving surface (34A) of a support stand device (2, 70), for protecting said housing while said housing is fastened to said support stand device by clamping force of a fastening mechanism (19, 75) in placing said lower housing surface on said receiving surface;
a plurality of elastic foot pads (44, 50, 63), disposed on said lower housing surface, offset from said protective sheet, for supporting said housing on a placement surface (3A) upon placing said housing thereon, wherein said foot pads are compressed elastically by said clamping force upon coupling said housing on said support stand device, and come to have a range equal to or less than a thickness (T) of said protective sheet
